# Europäisches Patentamt

# European Patent Office

# Office européen des brevets

(19)

(11) Publication number: **0 026 233**

**B1**

(12)

## EUROPEAN PATENT SPECIFICATION

(45) Date of publication of patent specification: 27.08.86

(21) Application number: 80900436.9

(22) Date of filing: 22.02.80

(86) International application number:
PCT/JP80/00025

(87) International publication number:
WO 80/01859 04.09.80 Gazette 80/20

(51) Int. Cl.⁴: **H 01 L 21/88,** H 01 L 21/82,
H 01 L 27/04

(54) SEMICONDUCTOR INTEGRATED CIRCUIT AND WIRING METHOD THEREFOR.

(30) Priority: 27.02.79 JP 22289/79

(43) Date of publication of application:
08.04.81 Bulletin 81/14

(45) Publication of the grant of the patent:
27.08.86 Bulletin 86/35

(84) Designated Contracting States:
DE FR GB

(56) References cited:

L'ONDE ELECTRIQUE, vol. 49, no. 502, January
1969, J.C. SAILLARD et al.: "Dessin
automatique des masques: le programme:
"Desmag", pages 92-97

COMPUTER, vol. 7, no. 3, May-June 1972, D.K.
LYNN: "Computer aided design for large-scale
integrated circuits", pages 36-45

Electronics (1967-2-20) (U.S.A.) C.E. Marvin and
R.M. Walker "Customizing by interconnection",
P157-164

Denshi Tsushin Gakkaishi, vol. 58, no. 4,
(1975-4), "LSI Haisen Jido Sekkei", P370-375

(73) Proprietor: FUJITSU LIMITED
1015, Kamikodanaka Nakahara-ku
Kawasaki-shi Kanagawa 211 (JP)

(72) Inventor: KIKUCHI, Hideo
1528, Takadacho, Kohoku-ku Yokohama-shi
Kanagawa 223 (JP)
Inventor: BABA, Shigenori
Kikuna-Heights 2-708 480-1 Mamedo-cho
Kohoku-ku
Yokohama-shi Kanagawa, 222 (JP)
Inventor: SATO, Shoji
6203-23-234, Tana, Sagamihara-shi
Kanagawa 229 (JP)

(74) Representative: Muir, Ian R. et al
HASELTINE LAKE & CO. Hazlitt House
28 Southampton Buildings Chancery Lane
London WC2A 1AT (GB)

EP 0 026 233 B1

# Description

The present invention relates to a method of wiring for a semiconductor integrated circuit, particularly a large-scale integrated circuit.

As is well known, the increase in the size of integrated circuit (IC) structures is continuing more and more and resultingly the layout of an IC can be made in circuit units (called "cells") such as NAND gates, or flip-flops instead of from individual transistors and wiring is carried out using a wiring grid system whereby connection between cells can be established. Thereby, the amount of information considered at the time of designing can be reduced and the processing rate can also be improved. The wiring pattern is produced on this grid wiring system at a size much larger than the actual size and then utilised, reduced in size, on the IC devices, commonly with some connections being made in multiple layers of wiring. The IC pattern layout space is partitioned in the form of a grid in dimensions larger than the minimum dimension for actual patterning of the wiring material layer in the fabrication of the ICs, for example, with the vertical and horizontal lines having an interval of wiring pitch which when multiplied by the reduction scale or factor gives the actual IC wiring interval, and the wiring pattern is depicted on such vertical and horizontal lines. The minimum allowable wiring pitch differs in accordance with the wiring layer location, whether, for example, it is on a 1st or 2nd layer, and with the wiring connection material used, such as aluminium, polysilicon or diffusion layer.

For example, in the case of 1st layer wiring using aluminium, the allowable actual minimum line interval is 10 μm; or in the case of polysilicon it is 10 μm, whilst the allowable minimum for the 2nd layer using aluminium is 15 μm. For such a case a grid system known to the applicant employs a rectangular mesh having a horizontal line interval responding, after reduction, to 10 μm and a vertical line interval corresponding to 15 μm. Use of this grid allows the correct drawing of wiring patterns of the 1st layer with the allowable minimum line interval by only depicting the lines indicating that layer wiring on the horizontal lines, and also allows the correct drawing of the 2nd layer wiring pattern by only depicting that 2nd layer wiring on the vertical lines. Thus, wiring masks can be generated on the basis of this grid system and wiring of the IC can be produced through the known photographic process, etc.

Prior to employing the above-described grid system for designing the pattern of the IC semiconductor device, usually graph or section paper with a square mesh having equal horizontal and vertical line intervals was used for depicting the wiring pattern. Namely, lines indicating wiring connections were drawn on the horizontal or vertical lines of this section paper or between the horizontal and vertical lines. Then, such a drawing was reduced, for example by a factor of 1000 to 1/1000 of original size (so that when the graph paper had a line interval of 1 mm, it was reduced down to approximately 1 μm or 0.5 μm which almost corresponds to the minimum actual dimensions of the patterning wires) in order to obtain the mask. In this method using such section paper, it is necessary to check whether or not the interval between wiring patterns depicted is larger than the allowable minimum line interval, and this check is very troublesome when an IC has been increasingly scaled up.

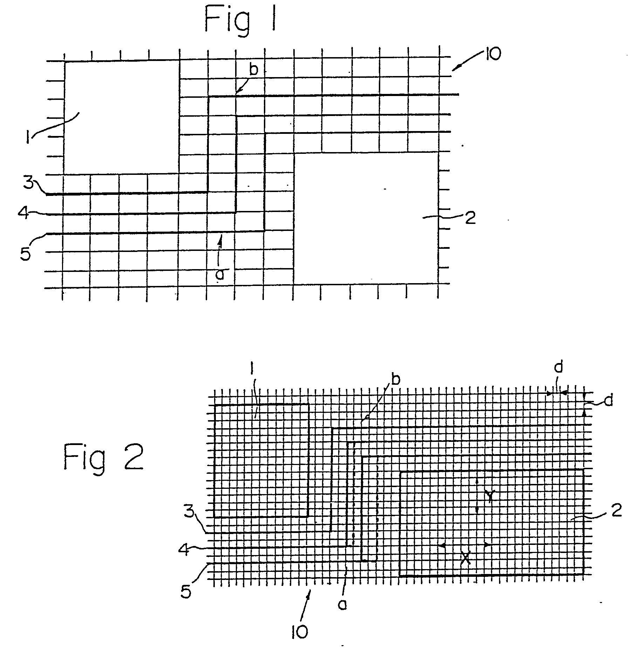

With regard to this latter point, the above-mentioned grid system is very convenient and the minimum wiring interval requirements are always satisfied when the rule that the wiring should always be depicted on the grid (vertical, horizontal lines) is observed and the appropriate reduction factor is used. Therefore, a line interval size check is not required when using this grid system. However, in the grid system known to the applicant, for example, the horizontal lines are used for the 1st layer individually, whilst the vertical lines are used for the 2nd layer (thereby the allowable minimum line interval for each layer can easily be reserved). In the case where cells 1 and 2 exist as shown in Fig. 1 and wiring is established between these cells and such that the wiring connections 3, 4, 5 must be bent at the regions a and b, the 1st layer wiring should be connected to the 2nd layer wiring at the region a, and the 2nd layer wiring should be connected to the 1st layer wiring again at the region b. Thus, the 1st layer and 2nd layer wirings are connected at the points a and b via through hole connections. This wiring method is very complicated, requiring a wider wiring area and deteriorating the yield. It is also possible to form wirings which are bent in the X and Y directions, such as the wirings 3, 4 and 5, on the same layer even in this existing grid system, but in this case, integration density is always deteriorated. Namely, if it is attempted to form the wirings 3, 4 and 5 on the 1st wiring layer, the vertical lines have the allowable minimum line interval of the 2nd layer which is larger than that of the 1st layer and the line interval is, therefore, wider than the necessary 1st layer interval. If it is attempted to form the wirings 3, 4 and 5 on the 2nd wiring layer, the horizontal line wiring must be depicted in alternate lines because if it is depicted on adjacent horizontal lines, the line interval after reduction is insufficient to meet the 2nd layer minimum interval. However, in this case, using alternate lines, the line interval becomes 10 μm × 2 which is larger than the 15 μm required. Thus, in either case, the line interval becomes large in the vertical or horizontal line portions of the wiring, resulting in a deterioration of integration density.

When the cell system is employed in the IC manufacture, a size of cell is selected to be equal to an integer times the grid interval, and when the cell is disposed within a chip the input and output terminals are usually arranged on the effective vertical and horizontal lines of the grid. Where such a cell system is employed with said described existing grid system, since the intervals of the vertical and horizontal lines differ, if a cell orientation is rotated by 90 degrees (the requirement of rotation through 90 degrees often occurs due to the convenience of connections, etc.), the problem arises that the terminals of the cell do not then always match the arrangement of vertical and horizontal lines. Such a problem reduces the degree of freedom of layout and also restricts improvement in integration density.

In the existing graph or section paper system, since the mesh is formed of small squares, the line interval will not exceed the necessary interval even if the wirings bending to the X and Y directions like the wirings 3, 4 and 5 are formed as the same wiring layer, and moreover the cell can be rotated easily through 90 degrees, without generating the problem that the cell terminals do not match the vertical and horizontal lines. But, as mentioned previously, this system has the very troublesome problem that all the line intervals of the wiring patterns depicted must be checked, and in addition, processing for the layout is complicated due to the large degree of freedom in the layout and it is very difficult to effect automatic layout of the wiring pattern. Methods of automatic layout are, for example, disclosed in L'ONDE ELECTRIQUE, vol. 49, no. 502, January 1969, J.C. Saillard et al.: "Dessen Automatique des Masques: le programme: "Desmag", pages 92—97 and COMPUTER, vol. 7, no. 3, May—June 1972, D.K. Lyon "Computer-aided design for large-scale integrated circuits", pages 36—45.

The present invention seeks to provide a wiring method for a semiconductor integrated circuit which can set the wiring interval to the allowable minimum value with simple checking and which allows bending of the wiring connections in the X and Y directions of wiring in the same layer without substantial deterioration of integration density.

According to the present invention there is provided a wiring method for producing multilayer wiring paths for the connection between cells of a semiconductor integrated circuit, with the wiring in each layer having a respective minimum allowable wiring pitch, the method including the laying out of the wiring paths along lines in a layout space in a layout grid system formed by vertical and horizontal lines, and then the using of the wiring layout patterns for each layer reduced in size by a factor to form the actual wiring paths on the respective layer of the integrated circuit, wherein the grid has the same interval between horizontal and vertical grid lines, the interval is selected to be equal to the greatest common measure of the minimum allowable wiring pitches of the multiple layers increased by said factor, and the pattern of wiring paths to be in the same layer are laid out on the vertical and horizontal lines with the same minimum interval therebetween equal to the minimum allowable wiring pitch for that layer increased by said factor.

By the expression "greatest common measure" of the minimum wiring pitches is meant the largest measurement which can be multiplied by respective integers to produce each of the minimum pitches. Where the accurate greatest common measure would be small and require to be multiplied by a number significantly larger than two, for example five, to produce the smallest of the minimum wiring pitches, then a higher than necessary minimum pitch may be assumed for the one or more of the minimum pitches which would otherwise render the greatest common measure so small. As an illustration, if there are two minimum pitches of 10 μm and 14 μm which would result in an accurate greatest common measure of 2 μm, the minimum pitches may be taken as 10 μm and 15 μm to produce a greatest common measure of 5 μm. Similarly, if one of the minimum pitches is a prime number such as 17 μm, then an appropriately larger minimum pitch may be assumed, e.g. 20, if as in the above example, a pitch of 5 μm is a satisfactory greatest common measure for the other minimum pitches. The expression "greatest common measure" used above is intended to be taken to include the practical greatest common measure obtained by making such adjustment to the minimum pitches.

For a better understanding of the present invention reference will now be made, by way of example, to the accompanying drawings, in which,

Fig. 1 is an explanatory diagram of an existing wiring method,

Fig. 2 is an explanatory diagram of the wiring method of this invention,

Fig. 3 is a diagrammatic example of cell layout,

Fig. 4 is a plan view showing an example of an IC cell layout using the present invention,

Fig. 5 is an equivalent circuit of the cell shown in Fig. 4, and

Fig. 6 shows in plan view a layout with two of the cells shown in Fig. 4 which are rotated by 90 degrees, with respect to one another.

The preferred embodiment of the present invention will be explained by referring to the drawings.

Fig. 2 illustrates a wiring method of the present invention. In Fig. 2, 10 is a grid with the same interval for the vertical lines and horizontal lines, forming square meshes. This vertical and horizontal line interval d should be selected to equate with the greatest common measure 5 μm when the allowable minimum pitch of the 1st layer wiring is 10 μm, while that of the 2nd wiring layer is 15 μm. Thus, the 1st and 2nd layer wirings assuring allowable minimum line interval can be depicted easily by depicting the wiring of the 1st layer on the vertical and horizontal lines in every other line, while the wiring of the 2nd layer on the vertical and horizontal lines with two unused intervening lines. In the case of laying out a wiring pattern which bends at right angles at the portions a and b, like the wirings 3, 4, 5, the 1st layer wiring pattern can be depicted by only drawing the connection lines on the vertical and horizontal lines in every other line (in practice, a line having a specific width must be drawn since the wiring has a certain width, but in this figure and explanation the width is ignored for simplification), and there is no need to form the wiring at the portions a and b on the 2nd layer. Of course, the wirings 3, 4, 5 may be formed on the 2nd wiring layer. For this layer, what is required is the drawing of wiring patterns for both the vertical and horizontal parts on the vertical and horizontal lines of grid with two intervening unused lines. If there are to be other wirings between the cells 1 and 2 and the wirings 3, 4, 5 cross these other wirings between the portions a and b, it can be avoided by forming the wiring between the portions a and b of the wirings 3, 4, 5 in the 2nd layer (assuming that said other wiring between the cells 1 and 2 and the lateral portion of the wirings 3 to 5 are to be in the 1st layer). But in this case, what is required is the drawing of only the part between a and b of the wirings 3 to 5 on the vertical lines with two intervening lines — as shown by the dotted line in Fig. 2.

As explained above, in this grid system, wiring patterns can be provided where the wiring of each layer complies with the allowable minimum line interval and the line interval does not exceed the required interval thereby improving the integration density by drawing the wiring patterns whilst observing the rule that the pattern of the 1st layer should be depicted on vertical and horizontal lines in every other line, whilst that of the 2nd layer must have two intervening lines. Of course, it goes without saying that it is also possible to make wirings with an interval larger than that mentioned above for the requirement of connection with cell terminals or for other conditions. The check required for the wiring patterns depicted is to check for the use of adjacent grid lines or use of the grid one or two lines apart, breaking the rule that the pattern for the respective layers should be drawn in every other line or with two intervening lines, so that the check whether each individual wiring pitch maintains an interval of 10 µm or 15 µm or not which has to be carried out for the existing section or graph paper system is no longer required.

This brings a large advantage. Namely, in the case of the system shown in Fig. 2, the check of wiring pitch can be done (for the first layer wiring), for example, by storing the horizontal part of each wiring pattern in a memory (1 or 0 for each horizontal line according to the line depicted or not depicted on such horizontal line with the X coordinate considered as an address), storing in the same way the vertical part in the memory and by checking whether the line is depicted in the horizontal part in both sides of each line (including the part a little preceding the line because the diagonal direction should also be considered), i.e. checking whether 1 is stored or not (it should not be stored in the normal condition). This check can be carried out with comparative ease.

If this checking method is also used for the section or graph paper system, the check is very complicated because a segment must be stored for each vertical and horizontal line of a minute section (a difference of checking of 5 times is generated compared with the above-mentioned unit of 5 µm and 10 µm), and therefore the required memory capacity increases (5 × 5 = 25 times in above example), and the interval check should be done for the 1st, 2nd, 3rd, 4th and 5th vertical and horizontal lines on both sides.

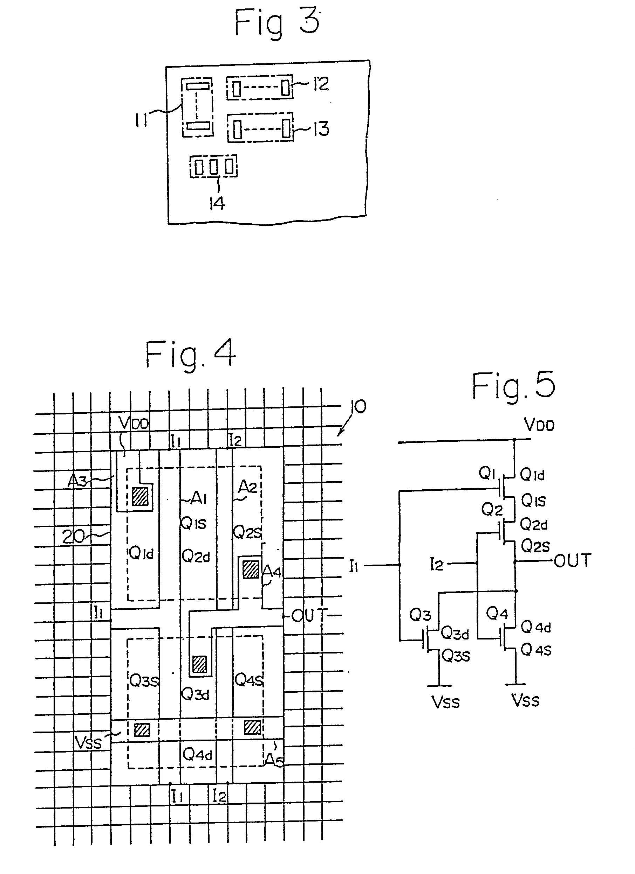

Sometimes, it is more convenient in an integrated circuit, from the point of view of connections and use of space, to position a cell, like the cell group 11 in Fig. 3, which is rotated by 90° with respect to the other cell groups 12, 13. In the case of present invention utilizing square grids, such rotation by 90° can be done freely simply by selecting the vertical and horizontal dimensions of the cell to be an integer times the grid interval, so that even when the cell group is rotated, the cell terminals can easily be matched to the wirings. However, in the case of the existing grid of Fig. 1 where the vertical line interval and horizontal line interval are not equal, if a cell group is rotated by 90 degrees, the sides of cell do not match the vertical and horizontal lines of the grid and in addition the cell terminals do not match the wirings.

The existing system of Fig. 1 requires only the observation of the rule that the 1st layer wiring should be depicted on the horizontal lines, whilst the 2nd layer wiring on the vertical lines. Thereby, the allowable minimum line interval of each layer can be acquired, and an interval check is no longer required, except for a visual check to confirm that each wiring pattern exists only on the vertical and horizontal lines of grid which is necessary only for ensuring further reliability. But this existing method has the disadvantages that the vertical part and horizontal part of the wiring are separated on the different layers and an attempt to establish the wiring on the same layer in order to avoid such a demerit causes the use in one direction of a line interval which is larger than the necessary interval.

In short, the section or graph paper system assures high flexibility due to excessive degree of freedom but is not suited for automatic wiring due to complicated programming. On the contrary, the existing grid system of Fig. 1 is very simplified, and is suitable for application of the line search method (the empty vertical and horizontal lines are searched according to the connection command and when an empty line is found, wiring is depicted on it) and the channel router (for example, the necessary vertical line group is depicted along the grid vertical line at the time of connecting between cells 1 and 2, and then terminals of cells 1 and 2 connected in common using the above vertical lines as the bus line are connected by the horizontal lines), but this method has the disadvantage that degree of freedom in layout is small because the horizontal wirings are used as the 1st wiring layer and the vertical wirings are used as the 2nd wiring layer. The present invention has succeeded in introducing advantages of both systems and eliminating disadvantages. In other words, the maintained concept of the grid has simplified the check of wirings and the high degree of freedom can prevent complication of wirings, reduction of integration density and deterioration of characteristic.

In the present invention the grid interval is determined on the basis of the minimum wiring pitch of each wiring layer but in the case where the accurate greatest common measure would be very small (in which case many vertical and horizontal lines must be depicted between the wiring patterns of each layer), the minimum wiring pitch is selected to a value which is larger than the allowable minimum pitch and which is convenient for use. For example, in the case where the allowable minimum pitches are not 10 μm and 15 μm, but 10 μm and 14 μm, and therefore the accurate greatest common measure is 2 μm, it is recommended to change the second minimum wiring pitch from 14 μm to 15 μm and take 5 μm as the greatest common measure. Moreover, in the case where three or more wiring layers are used, the grid pitch should be determined by the greatest common measure among these layers. In practice, when the allowable minimum interval of a 3rd layer in the above example is 17 μm, wiring can be made using a grid of 5 μm as the greatest common measure of these three layers. In the case where more layers are used for wirings, the grid pitch should be selected to the greatest common measure of the allowable minimum line intervals of all these layers. In this case also, adjustment is necessary so that said pitch is not selected to an excessively small value.

Fig. 4 shows an embodiment of a cell of a semiconductor integrated circuit generated by said wiring method.

In this figure, 10 is a grid shown in Fig. 2 having an interval of 5 μm which is the greatest common measure of the wiring pitches of wiring layers of 1st layer, 2nd layer and ... of an integrated circuit, for the wiring pitch of the 1st layer of 10 μm and 15 μm of the 2nd layer in the preceding example. 20 is a cell similar to 1, and 2 in the above example. The vertical and horizontal dimensions are selected to be an integer times of the interval (5 μm) of the square mesh grid 10. In this example, this cell 20 is selected to have such dimensions as 5 × 18 μm in the vertical direction and 5 × 9 μm in the horizontal direction. This cell 20 is a CMOS NOR gate with 2-inputs and its equivalent circuit is shown in Fig. 5. Correspondence between the source and drain of the FET's Q1 to Q4 in Fig. 4 and Fig. 5 is indicated by the symbols Q1s, Q1d ... $I_1$ and $I_2$ are input terminals; OUT is an output terminal; $V_{DD}$, $V_{SS}$ are power sources; $A_1$, $A_2$ are polycrystalline silicon patterns; $A_3$ to $A_5$ are aluminium wiring patterns; and the diagonally hatched rectangles are contact windows. As shown in this figure, the terminals $I_1$, $I_2$ OUT, $V_{DD}$, $V_{SS}$ of the cell 20 are provided on the area of grid allowing wirings (in above example, the area keeping at least 10 μm interval for the 1st layer of 15 μm interval for the 2nd layer). Thus, even when a cell 20 is rotated 90 degrees, the cell edges match the vertical and horizontal lines of the grid and also matches each terminal and wiring. Therefore, rotation of 90 degrees can be done freely and easily without any problems.

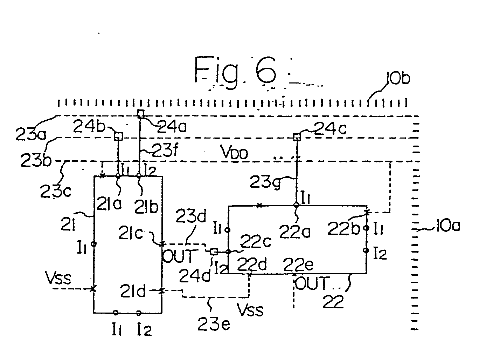

Fig. 6 is an example of a cell positioned with a rotation of 90 degrees. In this figure, 21, 22 are cells disposed in vertically and horizontally; 10a, 10b are vertical and horizontal intervals of the grid. In this example, the cells, 21, 22 have the same dimensions where the longer side is 18 times the grid interval, while the shorter side is 9 times the grid interval. 21a, 21b, ... 22a, 22b, ... are terminals which are arranged with the interval larger than the allowable minimum line interval and being matched with the vertical and horizontal lines of grid. Therefore, they easily and accurately match the wirings 23a, 23b, ... manufactured by the grid system. 24a, 24b, ... are contact windows. The wiring 23d connected by the contact window 24d is respectively provided on the 2nd layer on the left side of figure and 1st layer on the right side.

Here, it is not always required that the wirings in the cell follow the wiring method of the present invention, and wiring may be done at the outside of the grid.

In the wiring of cell, if one or several wirings are made not conforming to the wiring method of the present invention in the broader wiring area but when majority of wirings is made conforming to the wiring method of the present invention, such wiring should be covered by the present invention.

As is explained above, according to the present invention, wiring layout of an IC can be simplified and automatic wiring becomes possible. In addition, a high degree of freedom in circuit design can be obtained. Thus, advancement of DA for layout directly brings about easy manufacture of a large-scale integrated circuit having high integration density and performance.

**Claims**

1. A wiring method for producing multilayer wiring paths (3, 4, 5) for the connection between cells (1, 2) of a semiconductor integrated circuit, with the wiring in each layer having a respective minimum allowable wiring pitch, the method including the laying out of the wiring paths (3, 4, 5) along lines in a layout space in a layout grid system (10) formed by vertical and horizontal lines, and then the using of the wiring layout patterns for each layer reduced in size by a factor to form the actual wiring paths on the respective layer of the integrated circuit, wherein the grid (10) has the same interval (d) between horizontal and vertical grid lines, the interval (d) is selected to be equal to the greatest common measure of the minimum allowable wiring pitches of the multiple layers increased by said factor, and the pattern of wiring paths to be in the same layer are laid out on the vertical and horizontal lines with the same minimum interval therebetween equal to the minimum allowable wiring pitch for that layer increased by said factor.

2. A wiring method as claimed in claim 1, wherein a layout value equal to 1/2 of the minimum allowable wiring pitch of a 1st wiring layer increased by said factor is made equal to that of a 1/3 of the minimum allowable wiring pitch of a 2nd wiring layer increased by said factor and this value is selected as said same interval (d) of the vertical and horizontal lines of grid; and

a wiring pattern of the 1st wiring layer is made with wiring depicted on vertical and horizontal lines being spaced by at least one other line, while the wiring pattern of the 2nd wiring layer is depicted on vertical and horizontal lines being spaced by at least two other lines.

3. A wiring method according to claim 1 or 2 wherein the cell units (20, 21, 22) to be wired in the integrated circuit are arranged to have side lengths each correspondingly equal to an integral multiple of said interval (d) in the layout system, and the wiring terminals therefor are arranged to lie on wiring locations on said horizontal and vertical lines.

**Patentansprüche**

1. Verdrahtungsverfahren zur Herstellung mehrschichtiger Verdrahtungswege (3, 4, 5) für die Verbindung zwischen Zellen (1, 2) einer integrierten Halbleiterschaltung, wobei die Verdrahtung in jeder Schicht jeweils einen minimalen zulässigen Verdrahtungsabstand hat und das Verfahren das Auslegen der Verdrahtungswege (3, 4, 5) längs Linien in einem Auslegerarm in einem Auslegegittersystem (10) umfaßt, welches durch vertikale und horizontale Linien gebildet ist, und dann die Verdrahtungsauslegemuster für jede Schicht in der Größe um einen Faktor reduziert werden, um die tatsächlichen Verdrahtungswege auf der entsprechenden Schicht der integrierten Halbleiterschaltung zu bilden, wobei das Gitter (10) dieselben Intervalle (d) zwischen horizontalen und vertikalen Gitterlinien hat, das Intervall (d) so ausgewählt ist, daß es gleich dem größten gemeinsamen Maß der minimal zulässigen Verdrahtungsabstände der Mehrfachschichten, vergrößert um den genannten Faktor, ist und das Muster der Verdrahtungswege, die in derselben Schicht sein sollen, auf den vertikalen und horizontalen Linien mit demselben minimalen Intervall dazwischen gleich dem minimal zulässigen Verdrahtungsabstand für diejenige Schicht, vergrößert um den genannten Faktor, ist.

2. Verdrahtungsverfahren nach Anspruch 1, bei welchem ein Auslegewert gleich 1/2 des minimal zulässigen Verdrahtungsabstandes einer ersten Verdrahtungsschicht, vergrößert um den genannten Faktor, gleich demjenigen von 1/3 des minimal zulässigen Verdrahtungsabstandes einer zweiten Verdrahtungsschicht, vergrößert um den genannten Faktor, gemacht wird und dieser Wert als das genannte selbe Intervall (d) der vertikalen und horizontalen Linien des Gitters ausgewählt wird; und ein Verdrahtungsmuster der ersten Verdrahtungsschicht mit der Verdrahtung auf vertikalen und horizontalen Linien dargestellt, gemacht wird, die einen Abstand von wenigstens einer anderen Linie voneinander haben, während das Verdrahtungsmuster der zweiten Verdrahtungsschicht auf vertikalen und horizontalen Linien dargestellt wird, die einen Abstand von wenigstens zwei anderen Linien voneinander haben.

3. Verdrahtungsverfahren nach Anspruch 1 oder 2, bei welchem die Zelleneinheiten (20, 21, 22), die in der integrierten Schaltung verdrahtet werden sollen, so angeordnet sind, daß sie Seitenlängen haben, welche jeweils gleich einem ganzzahligen Vielfachen des genannten Intervalls (d) in dem Auslegesystem sind, und die Verdrahtungsanschlüsse dafür so angeordnet sind, daß sie auf Verdrahtungsorten auf horizontalen und vertikalen Linien liegen.

**Revendications**

1. Procédé de câblage permettant de produire des trajets de câblage multicouche (3, 4, 5) destinés à établir les connexions entre des cellules (1, 2) d'un circuit intégré à semiconducteur, le câblage de chaque couche ayant un pas de câblage admissible minimal respectif, le procédé comprenant le tracé des trajets de câblage (3, 4, 5) le long de lignes d'un espace de tracé existant dans un système à grille de tracé (10) formé par des lignes verticales et horizontales, puis l'utilisation des configurations de tracé de câblage relatives à chaque couche réduites en taille d'un certain facteur dans le but de former les trajets de câblage réels sur la couche respective du circuit intégré, où la grille (10) possède un même intervalle (d) entre lignes de grille horizontales et verticales,

l'intervalle (d) est choisi de façon à être égal au plus grand commun diviseur des pas de câblage admissibles minimaux des couches multiples augmentés par ledit facteur, et les configurations de trajets de câblage à mettre dans la même couche sont disposées sur les lignes verticales et horizontales de façon que le même intervalle minimal existant entre eux soit égal au pas de câblage admissible minimal pour cette couche augmenté par ledit facteur.

2. Procédé de câblage selon la revendication 1, où on établit l'égalité entre une valeur de tracé égale à la moitié du pas de câblage admissible minimal d'une première couche de câblage augmenté par ledit facteur et celle d'un tiers du pas de câblage admissible minimal d'une deuxième couche de câblage augmenté par ledit facteur, on choisit cette valeur comme ledit intervalle identique (d) des lignes verticales et horizontales de la grille; et on réalise une configuration de câblage de la première couche de câblage de façon que le câblage soit tracé sur des lignes verticales et horizontales qui sont séparées chacune d'au moins une ligne, tandis que la configuration de câblage de la deuxième couche de câblage est tracée sur des lignes verticales et horizontales qui sont séparées chacune d'au moins deux lignes.

3. Procédé de câblage selon la revendication 1 ou 2, où les cellules unitaires (20, 21, 22) à câbler dans le circuit intégré sont conçues de façon à avoir des côtés dont les longueurs sont chacune, de manière correspondante, égales à un multiple entier dudit intervalle (d) du système de tracé, et les bornes de câblage associées sont destinées à se trouver sur des emplacements de câblage existant sur lesdites lignes horizontales et verticales.

# Fig 1

# Fig 2

# Fig 3

# Fig. 4

# Fig.5

Fig. 6